# EUROPEAN PATENT APPLICATION

(11) **EP 3 664 285 A1**
(43) Date of publication of application: **10.06.2020**
(21) Application number: 18215384.1
(22) Date of filing: 21.12.2018
(51) Int. Cl.: H02S 50/00, H02S 40/12, H02S 40/42, H01L 31/048, H01L 31/049

(54) **HIGH EFFICIENCY SOLAR MODULE**

(30) Priority: 03.12.2018 KR 20180153680
(71) Applicant: Solasidokorea Co., Ltd., Jeollabuk-Do (KR)
(72) Inventor: YOUN, Chang Bok, 110-201 Jeollabuk-do (KR)
(74) Representative: TBK

(57) **Abstract**

Disclosed herein is a high efficiency solar module, the high efficiency solar module includes a solar cell panel formed by layering a frame, a glass, a front Ethyl Vinyl Acetate (EVA), a solar cell, a rear EVA, a carbon fiber plate heating element, a back seat, and a carbon coating film in order, and a snow removal device for melting snow piled up on the solar cell panel, and the snow removal device includes a monitoring part for checking whether or not snow is piled up on the solar cell panel through a CCTV monitor, a reverse bias supplier for sending a current of a battery to the solar cell, and a controller for controlling the monitoring part, the battery, and the reverse bias supplier.

## Description

### BACKGROUND OF THE INVENTION

### Field of the Invention

The present invention generally relates to a high efficiency solar module and, more particularly, to a high efficiency solar module with heat radiation and snow removal functions.

### Description of the Related Art

In recent years, due to acceleration of global warming and scarce resources, interest in new-and-renewable energy that is eco-friendly energy is growing. Particularly, a solar power generation system, which does not consume fuel and does not generate pollution, noise, and vibration, is easy to add to facilities, is capable of being used semi-permanently, and has less maintenance cost, which is an advantageous.

On the other hand, the solar power generation system has a disadvantage of being weak in natural disasters because the system is installed while being exposed to the outside. For example, in winter, due to snow piled up on a solar module, the efficiency of solar power generation decreases and a support of the solar module may collapse, and thus development of a snow removal device for a solar module is necessary.

However, as a snow removal device of a conventional solar module, a snow removal device using a wiper is provided, but when snow on the solar cell panel is frozen, the wiper stops operating or is damaged. Therefore, it is necessary to add a snow removal device that determines whether or not snow is piled up on a solar module and automatically performs a snow removal function on the solar module.

In addition, when temperature of a solar module rises, power performance thereof decreases generally. Therefore, a technique of reducing temperature of the solar module is necessary in order to improve efficiency of the solar module.

### SUMMARY OF THE INVENTION

Accordingly, the present invention has been made keeping in mind the above problems occurring in the related art, and the present invention is intended to propose a high efficiency solar module for increasing efficiency of solar power by applying a carbon composite, a carbon fiber plate heating element, and a snow removal device to a solar cell panel of the solar module.

In order to achieve the above object, according to one aspect of the present invention, there is provided a high efficiency solar module, including: a solar cell panel formed by layering a frame, a glass, a front Ethyl Vinyl Acetate (EVA), a solar cell, a rear EVA, a carbon fiber plate heating element, a back seat, and a carbon coating film in order; and a snow removal device for melting snow piled up on the solar cell panel. Here, the snow removal device includes a monitoring part for checking whether or not snow is piled up on the solar cell panel through a CCTV monitor, a reverse bias supplier for sending a current of a battery to the solar cell, and a controller for controlling the monitoring part, the battery, and the reverse bias supplier.

The carbon fiber plate heating element may be formed in a rectangular shaped pattern in order to increase radiating heat performance.

The carbon coating film is formed by printing a composite material obtained by mixing carbon, graphite, and binder.

When the controller controls the reverse bias supplier to turn on (ON) a switch (SW), a voltage of the battery sends the current to the solar cell through a resistor (R) and the switch (SW) of the reverse bias supplier to heat the solar cell, accordingly, the snow removal device can melt snow on the solar cell panel.

As mentioned above, according to the present invention, efficiency of solar power generation can be improved by reducing temperature of a solar module in normal times by using the carbon composite and the carbon fiber plate heating element and removing snow in winter by using the snow removal device.

### BRIEF DESCRIPTION OF THE DRAWINGS

The above and other objects, features and other advantages of the present invention will be more clearly understood from the following detailed description when taken in conjunction with the accompanying drawings, in which:
FIG. 1 is a block diagram showing a constitution of a high efficiency solar module according to the present invention.
FIG. 2 is an assembly view of a solar cell panel according to the present invention.

### DETAILED DESCRIPTION OF THE INVENTION

Hereinbelow, exemplary embodiments of the present invention will be described in detail with reference to the accompanying drawings such that the invention can be easily embodied by one of ordinary skill in the art to which this invention belongs. Various changes to the following embodiments are possible and the present invention is not limited to the following embodiments.

Hereinbelow, a high efficiency solar module according to an exemplary embodiment of the present invention will be described in detail.

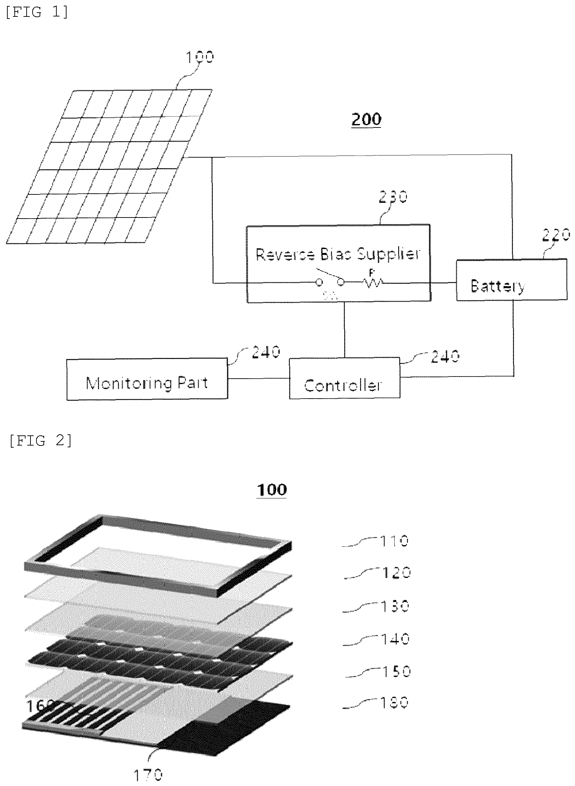

FIG. 1 is a block diagram showing a constitution of the high efficiency solar module according to the present invention, and FIG. 2 is an assembly view of a solar cell panel according to the present invention.

Referring to FIGS. 1 and 2, the high efficiency solar module according to the present invention includes a snow removal device 200 which melts snow piled up on the inclined solar cell panel 100.

The solar cell panel 100 is constituted by layering a frame 110, a glass 120, a front Ethyl Vinyl Acetate (130; EVA), a solar cell 140, a rear EVA 150, a carbon fiber plate heating element 160, a back sheet 170, and a carbon coating film 180 in order. Here, the frame 110, the glass 120, the front EVA 130, the solar cell 140, the rear EVA 150, the back sheet 170 which constitute the solar cell panel 100 are well-known technologies, so a detailed description thereof is omitted.

The carbon fiber plate heating element 160 may be formed in a rectangular shaped pattern in order to increase radiating heat performance, but the present invention is not limited thereto.

The carbon coating film 180 is formed by printing a composite material obtained by mixing carbon, graphite, and a binder.

As multiple functions of planar heating and heat radiation are realized by the carbon fiber plate heating element 160 and the carbon coating film 180, it is possible to increase efficiency of solar power generation by reducing decline of solar power efficiency due to overheating of solar cell in summer.

The snow removal device 200 supplies stored electricity, obtained by receiving solar energy and converting the solar energy into electric energy, back to the solar cell, which can heat the solar cell to melt snow.

Here, the snow removal device 200 may include a monitoring part 210 for checking whether or not snow is piled up on the solar cell panel 100 through a CCTV monitor, a reverse bias supplier 230 for sending a current of a battery 220 to the solar cell, and a controller 240 for controlling the monitoring part 210, the battery 220, and the reverse bias supplier 230.

When the snow removal device 200 confirms that snow is piled up on the solar cell panel 100 using the monitoring part 210, the controller 240 controls the reverse bias supplier 230 to turn on (ON) a switch (SW), and then a voltage of the battery 220 sends the current to the solar cell through a resistor (R) and the switch (SW) of the reverse bias supplier 230 to heat the solar cell. Accordingly, the snow on the solar cell panel 100 can be removed by being melted.

Consequently, the snow removal device 200 can remove the snow more quickly, easily, and efficiently, and thus can prevent loss of function of the solar cell due to snow in winter.

Although a preferred embodiment of the present invention has been described for illustrative purposes, those skilled in the art will appreciate that various modifications, additions and substitutions are possible, without departing from the scope and spirit of the invention as disclosed in the accompanying claims.

Disclosed herein is a high efficiency solar module, the high efficiency solar module includes a solar cell panel formed by layering a frame, a glass, a front Ethyl Vinyl Acetate (EVA), a solar cell, a rear EVA, a carbon fiber plate heating element, a back seat, and a carbon coating film in order, and a snow removal device for melting snow piled up on the solar cell panel, and the snow removal device includes a monitoring part for checking whether or not snow is piled up on the solar cell panel through a CCTV monitor, a reverse bias supplier for sending a current of a battery to the solar cell, and a controller for controlling the monitoring part, the battery, and the reverse bias supplier.

## Claims

1. A high efficiency solar module, comprising:
a solar cell panel formed by layering a frame, a glass, a front Ethyl Vinyl Acetate (EVA), a solar cell, a rear EVA, a carbon fiber plate heating element, a back seat, and a carbon coating film in order; and
a snow removal device for melting snow piled up on the solar cell panel,
wherein the snow removal device includes a monitoring part for checking whether or not snow is piled up on the solar cell panel through a CCTV monitor, a reverse bias supplier for sending a current of a battery to the solar cell, and a controller for controlling the monitoring part, the battery, and the reverse bias supplier.

2. The high efficiency solar module of claim 1, wherein the carbon fiber plate heating element is formed in a rectangular shaped pattern in order to increase radiating heat performance.

3. The high efficiency solar module of claim 1, wherein the carbon coating film is formed by printing a composite material obtained by mixing carbon, graphite, and a binder.

4. The high efficiency solar module of claim 1, wherein, when the controller controls the reverse bias supplier to turn on (ON) a switch (SW), a voltage of the battery sends the current to the solar cell through a resistor (R) and the switch (SW) of the reverse bias supplier to heat the solar cell, accordingly, the snow removal device melts snow piled up on the solar cell panel.
